# FASCICULE DE BREVET EUROPEEN

(11) **EP 0 680 140 B1**
(45) Date de publication et mention de la délivrance du brevet: **03.02.1999**
(21) Numéro de dépôt: 95410038.4
(22) Date de dépôt: 26.04.1995
(51) Int. Cl.: H03F 3/45, H03F 3/30, H03F 3/26

(54) **Amplificateur différentiel à réglage de mode commun**
Differenzverstärker mit Gleichtaktregelung
Differential amplifier with common mode control

(30) Priorité: 29.04.1994 FR 9405501
(43) Date de publication de la demande: 02.11.1995
(73) Titulaire: STMicroelectronics S.A., 94250 Gentilly (FR)
(72) Inventeur: Weiss, Juliette, F-38170 Seyssinet Pariset (FR)
(74) Mandataire: de Beaumont, Michel

(56) Documents cités:
- EP-A- 0 486 332
- DE-A- 3 725 323
- US-A- 3 502 999
- PATENT ABSTRACTS OF JAPAN vol. 11 no. 376 (E-563) [2823] ,8 Décembre 1987 & JP-A-62 144412 (NEC CORP.) 27 Juin 1987,
- IEEE TRANSACTIONS ON NUCLEAR SCIENCE, vol. 37, no. 2, Avril 1990 NEW YORK US, pages 439-443, XP 000142892 T. ZIMMERMAN 'A HIGH SPEED, LOW NOISE ASIC PREAMPLIFIER FOR SILICON STRIP DETECTORS'

## Description

La présente invention telle qu'elle est définie dans les revendications concerne la réalisation d'un amplificateur à entrées et sorties différentielles et plus particulièrement d'un tel amplificateur susceptible de fonctionner à haute fréquenoe.

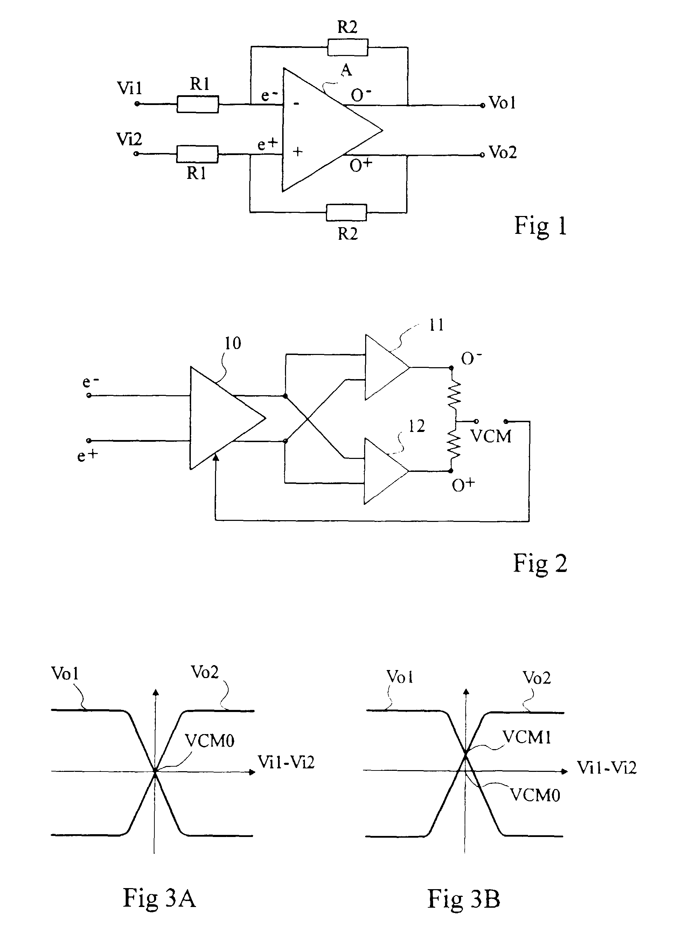

La figure 1 représente le montage classique d'un amplificateur à entrées et sorties différentielles. Cet amplificateur A est muni d'entrées e⁻ et e⁺ et de sorties o⁻ et o⁺. Pour qu'il fonctionne en amplificateur de gain déterminé, il est associé à un réseau de résistances comprenant une résistance R1 connectée à chacune des entrées et une résistanoe R2 connectée entre chacune des entrées et la sortie correspondante. Si on appelle Vi1 et Vi2 les tensions d'entrée et Vo1 et Vo2 les tensions de sortie, le gain de cet amplificateur est déterminé par la valeur des résistances. En effet, Vo1-Vo2=(-R2/R1)(Vi1-Vi2). Le gain différentiel est égal à -R2/R1.

Quand le signal d'entrée varie autour d'une valeur moyenne, les signaux de sortie varieront de même autour d'une valeur moyenne couramment appelée tension de mode commun VCM. Par ailleurs, chacune des sorties o⁺ et o⁻ peut, en raison de la constitution même de l'amplificateur différentiel, atteindre des valeurs respectivement minimale et maximale déterminées proches des tensions d'alimentation haute et basse du circuit intégré dans lequel est réalisé l'amplificateur différentiel. Pour éviter toute distorsion des signaux de sortie tout en profitant de la plage maximale d'excursion possible, il est souhaitable que la valeur VCM soit aussi précisément que possible centrée par rapport aux susdites valeurs minimale et maximale.

Pour obtenir un amplificateur complètement différentiel bien équilibré à fonctionnement satisfaisant à fréquence élevée, divers auteurs, par exemple K. Nakamura et al., IEEE Journal of Solid-State Circuits, volume 27, n°4, Avril 1992, pages 563-567, ont proposé d'utiliser des structures telles que celle illustrée en figure 2. Ces structures, dites amplificateur complètement différentiel du type translateur de niveau, comprennent une paire différentielle d'entrée 10 à entrées et sorties différentielles suivie de deux préamplificateurs 11 et 12 à entrées différentielles couplées et à sortie unique. La caractéristique des tensions de sortie Vo1 et Vo2 en fonction de la tension d'entrée différentielle (Vi1-Vi2) devrait idéalement être telle qu'illustrée en figure 3A, c'est-à-dire que la tension de mode commun VCM est parfaitement centrée sur le milieu VCM0 des valeurs extrêmes des tensions Vo1 et Vo2. En fait, on constate qu'en pratique on obtient plutôt une caractéristique du type de celle de la figure 3B, à savoir que, quand la différence entre les tensions d'entrée est nulle, la tension de mode commun, c'est-à-dire le point de croisement des courbes Vo1 et Vo2, au lieu d'être égale à la valeur VCM0 centrée sur les valeurs extrêmes des tensions Vo1 et Vo2, est égale à une valeur VCM1. On trouve fréquemment des valeurs de VCM1 qui peuvent atteindre jusqu'à 20 % de l'écart entre les valeurs extrêmes des tensions Vo1 et Vo2.

Comme le représente la figure 2, pour pallier ces inconvénients, on a proposé dans l'art antérieur de détecter la valeur de la tension de mode commun VCM au moyen d'un pont résistif ou équivalent et d'injecter la valeur du déréglage de VCM dans une boucle de contre-réaction destinée à corriger le fonctionnement de la paire différentielle d'entrée 10.

Un exemple d'un tel montage est décrit dans l'article de M. Banu et al., IEEE Journal of Solid-State Circuits, Volume 23, N° 6, décembre 1988, pages 1410 à 1414. Ce procédé présente l'inconvénient de créer une boucle supplémentaire dans le circuit qui est d'autant plus critique que le produit gain-bande passante, c'est-à-dire la fréquenoe maximale de fonctionnement, est élevé puisque la boucle de mode commun doit avoir une largeur de bande aussi grande que la boucle du mode différentiel pour préserver la valeur globale du produit gain-bande passante.

Un autre exemple de ce type de montage est divulgé par le document EP-A-0 486 332.

Un objet de la présente invention est de prévoir un amplificateur complètement différentiel dans lequel la tension de mode commun peut être ajustée sans boucle de réaction.

Un autre objet de la présente invention est de prévoir un tel amplificateur complètement différentiel dans lequel la tension de mode commun peut être réglée à la fabrication.

Pour atteindre ces objets, la présente invention prévoit un amplificateur à entrées et sorties différentielles comprenant une paire différentielle d'entrée ; un premier et un deuxième préamplificateur de tension à entrée différentielle et à sortie unique recevant chacun les sorties de la paire différentielle ; un étage adaptateur d'impédance connecté à chaque préamplificateur et dont la sortie constitue une sortie de l'amplificateur ; un moyen unique d'ajustement du courant de repos envoyé par les préamplificateurs aux étages adaptateurs, d'où il résulte que la tension de mode commun peut être ajustée à une valeur souhaitée.

Selon un mode de réalisation de la présente invention, chaque préamplificateur comprend une première et une deuxième branches d'une paire de transistors à base commune, lesdites branches étant couplées par un miroir de courant, la sortie de la première branche constituant l'entrée d'un étage adaptateur, et la portion du miroir de courant associée à la deuxième branche comprend une résistance de réglage de courant commune aux deuxièmes branches des miroirs de courant de chacun des préamplificateurs.

Selon un mode de réalisation de la présente invention, la paire différentielle d'entrée comprend un premier et un deuxième transistors NPN dont les collecteurs sont reliés à une borne d'alimentation haute par des résistanoes de charge respectives, dont les bases reçoivent les entrées différentielles, et dont les émetteurs sont reliés ensemble à une borne d'alimentation basse par une source de courant ; chaque préamplificateur de tension comprend une paire de transistors à base commune constituée de troisième et quatrième transistors PNP dont les émetteurs sont reliés aux collecteurs des premier et deuxième transistors, dont les bases sont reliées à une tension de polarisation et dont les collecteurs sont reliés respectivement à l'entrée et à la sortie d'un miroir de courant, le collecteur du transistor de la première branche de la paire différentielle constituant la sortie vers l'étage adaptateur ; chaque miroir de courant comprend un cinquième et un sixième transistor NPN dont les collecteurs sont reliés aux collecteurs des troisième et quatrième transistors, dont les émetteurs sont reliés à la borne d'alimentation basse par l'intermédiaire de première et deuxième résistances respectives, et dont les bases sont reliées ensemble et au collecteur du transistor de ladite deuxième branche, la résistance de la deuxième branche du miroir de courant étant commune aux premier et deuxième préamplificateur et constituant ladite résistance de réglage.

Selon un mode de réalisation de la présente invention, la résistance de réglage est une résistance ajustable par fusibles ou par laser formée dans le circuit intégré contenant ledit amplificateur.

Selon un mode de réalisation de la présente invention, l'amplificateur est associé à des résistances de détermination de gain, et ces résistances sont formées dans le circuit intégré contenant ledit amplificateur.

Un avantage d'une telle structure réside dans le fait que, si la tension de mode commun est convenablement centrée, il devient possible de coupler directement en série, sans capacité de couplage, une succession d'amplificateurs de gain moyen pour obtenir un système amplificateur à gain élevé. Ceci est particulièrement intéressant du fait que de telles capacités sont difficilement intégrables (elles occuperaient une surface trop importante du circuit intégré).

Ces objets, caractéristiques et avantages ainsi que d'autres de la présente invention seront exposés en détail dans la description suivante de modes de réalisation particuliers faite à titre non-limitatif en relation avec les figures jointes parmi lesquelles :
les figures 1 à 3 destinées à exposer l'état de la technique et le problème posé ont été décrites précédemment ;
la figure 4 représente un schéma sous forme de blocs d'un amplificateur complètement différentiel selon la présente invention ;
la figure 5 représente à titre d'exemple un mode de réalisation utilisant des composants bipolaires d'un amplificateur selon la présente invention ; et
la figure 6 représente un mode de réalisation d'un adaptateur d'impédance de sortie d'un amplificateur selon la présente invention.

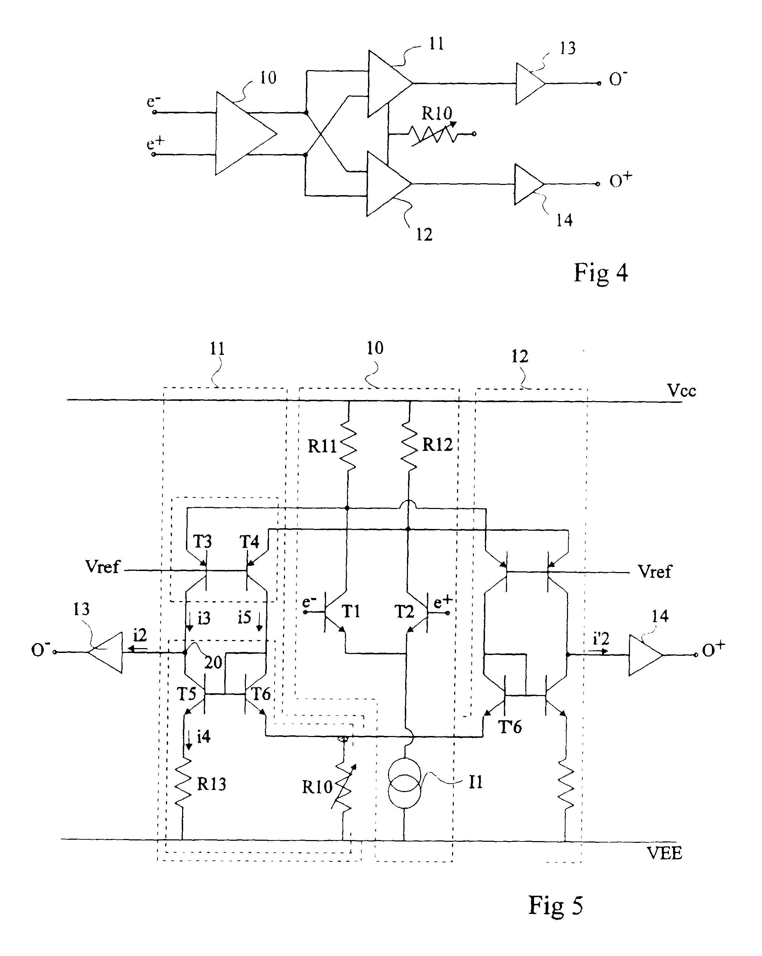

Comme le représente la figure 4, la présente invention utilise un montage d'amplificateur complètement différentiel du type translateur de niveau tel qu'illustré en figure 2. En outre, la sortie de chacun des préamplificateurs 11 et 12 est envoyée aux sorties finales o⁻ et o⁺ de l'amplificateur par l'intermédiaire d'amplificateurs adaptateurs d'impédance 13 et 14. Ces amplificateurs adaptateurs d'impédance sont classiquement de type émetteur-suiveur de gain unité permettant d'obtenir en sortie de l'amplificateur une impédance déterminée, de préférence de valeur faible pour que l'amplificateur puisse débiter un courant suffisant.

En outre, les préamplificateurs 11 et 12 sont prévus pour que leur courant de repos soit réglable. On entend par courant de repos le courant continu fourni par ces amplificateurs quand les tensions d'entrée sur les bornes e⁻ et e⁺ sont identiques. Plus particulièrement, la présente invention propose de choisir des amplificateurs 11 et 12 tels que leurs courants de repos soient réglables de façon commune par l'intermédiaire d'une seule résistance R10.

Bien entendu, en utilisation, l'amplificateur différentiel sera couplé à un réseau de résistances de détermination de gain telles que les résistanoes R1 et R2 de la figure 1. Dans une réalisation pratique, la demanderesse prévoit d'ailleurs d'intégrer ces résistanoes au circuit intégré incorporant les amplificateurs 10, 11, 12, 13, 14.

De même, la résistance R10 pourra être insérée dans le circuit intégré et réalisée sous forme d'une résistance ajustable par tout moyen classique, par exemple par fusibles ou par ajustage laser.

La figure 5 représente un mode de réalisation particulier de l'amplificateur différentiel de la figure 4 réalisé dans une technologie bipolaire.

La paire différentielle 10 comprend des transistors T1 et T2 de type NPN dont les collecteurs sont connectés par des résistances respectives R11 et R12 à une borne d'alimentation haute VCC et dont les émetteurs sont connectés par l'intermédiaire d'une source de courant I1 à une borne d'alimentation basse VEE. Les bases des transistors T1 et T2 correspondent respectivement aux entrées e⁻ et e⁺.

Les préamplificateurs 11 et 12 sont réalisés symétriquement de façon identique. Ainsi, seul le préamplificateur 11 sera décrit.

Le préamplificateur 11 comprend deux transistors PNP T3 et T4 montés en base commune ayant une fonction d'amplificateurs de courant. Les bases des transistors T3 et T4 sont reliés à une tension de polarisation fixe Vref. Les émetteurs respectifs des transistors T3 et T4 sont reliés aux collecteurs respectifs des transistors T1 et T2, c'est-à-dire à la sortie de la paire différentielle 10. Les collecteurs des transistors T3 et T4 sont respectivement connectés aux collecteurs de transistors respectifs T5 et T6 de type NPN montés en miroir de courant. Les bases des transistors T5 et T6 sont connectées entre elles et au collecteur du transistor T6. L'émetteur du transistor T5 est relié à l'alimentation VEE par une résistance R13 et l'émetteur du transistor T6 est relié à la borne d'alimentation VEE par l'intermédiaire de la résistance R10 déjà mentionnée en relation avec la figure 4.

On notera que la résistance R10 constituant la résistance d'émetteur du transistor T6 constitue aussi la résistance d'émetteur du transistor T'6 correspondant du préamplificateur 12. Les transistors T5 et T6 constituant comme on l'a mentionné précédemment un miroir de courant, le courant dans le transistor T5 est lié au courant traversant la résistance R10, dans le rapport des valeurs des résistances R13 et R10 (en supposant les transistors T5 et T6 identiques).

On désigne par la référence 20 le noeud commun des collecteurs des transistors T3 et T5 qui est relié à l'entrée de l'adaptateur d'impédance 13. On appelle tension de repos de ce noeud, la tension présente quand les tensions sur les entrées e⁻ et e⁺ sont égales. Alors, la tension sur la sortie o⁻ de l'amplificateur 13 correspond à la tension de mode commun. L'étage 13 étant un étage de gain unité à impédance d'entrée déterminée, cette tension sera la même que la tension sur la borne 20 et sera égale au produit du courant i2 injecté dans l'adaptateur 13 par la résistance d'entrée de cet adaptateur.

On désigne par i3 le courant de collecteur du transistor T3, par i4 le courant d'émetteur du transistor T5 et par i5 le courant de collecteur du transistor T4. Les courants i3 et i5, qui circulent respectivement dans les transistors T3 et T4 ont tous deux des valeurs prédéterminées sensiblement constantes puisque la tension Vref appliquée aux bases de ces transistors est fixe. En conséquence, si la valeur de la résistance R10 est ajustée, ceci a pour effet de modifier la tension base-émetteur du transistor T6 tandis que le courant i5 reste fixe. Puisque, comme on l'a indiqué ci-dessus, les transistors T5 et T6 sont connectés en miroir de courant, la tension base-émetteur du transistor T5 se modifie, ce qui règle alors la valeur du courant i4. Puisque le courant i3, qui est fixe, est égal à la somme des courants i2 et i4, tout changement du courant i4 produira un changement correspondant du courant i2. En particulier, si i4 croît, i2 décroît et inversement.

En conséquence, par un simple réglage de la valeur de la résistanoe R10, on ajuste le courant i2 à la sortie du préamplificateur 11. Ainsi, un ajustement du courant i2 entraîne un ajustement de la tension de mode commun du système.

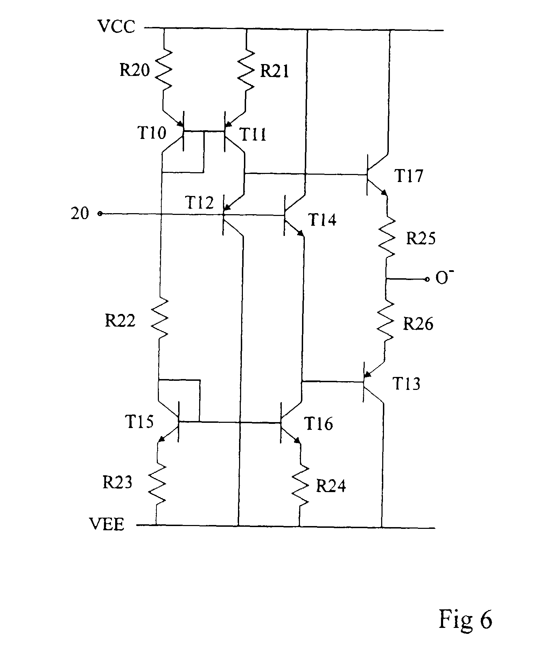

La figure 6 représente un schéma de circuit détaillé d'un exemple d'étage adaptateur typique de gain unité pouvant servir à réaliser l'adaptateur 13. L'adaptateur 14 sera identique à l'adaptateur 13. L'adaptateur comprend quatre transistors PNP T10, T11, T12 et T13 ; quatre transistors NPN T14, T15, T16 et T17 ; et sept résistanoes R20, R21, R22, R23, R24, R25 et R26.

Les émetteurs des transistors T10 et T11 sont respectivement connectés à l'alimentation positive Vcc par l'intermédiaire des résistances R20 et R21 et leurs bases sont connectées l'une à l'autre. La base du transistor T10 est également connectée à son collecteur.

Les émetteurs des transistors T15 et T16 sont respectivement connectés à l'alimentation négative VEE par l'intermédiaire des résistanoes R23 et R24 et leurs bases sont connectées l'une à l'autre. La base du transistor T15 est également connectée à son collecteur. Les collecteurs des transistors T10 et T15 sont connectés par l'intermédiaire de la résistance R22.

Les collecteurs des transistors T11 et T16 sont respectivement connectés aux émetteurs de transistors T12 et T14 dont les collecteurs respectifs sont connectés aux alimentations négative et positive, respectivement VEE et VCC. Les bases des transistors T12 et T14 sont connectées l'une à l'autre et forment l'entrée 20 de l'étage adaptateur d'impédance.

Les collecteurs respectifs des transistors T17 et T13 sont connectés aux alimentations positive et négative, respectivement VCC et VEE et leurs émetteurs respectifs sont connectés l'un à l'autre par l'intermédiaire des résistances R25 et R26. Le point de connexion des résistances R25 et R26 forme la sortie o- de l'adaptateur. La base du transistor T17 est connectée au collecteur du transistor T11 tandis que la base du transistor T13 est connectée au collecteur du transistor T16.

Les transistors T17 et T13 agissent comme un étage de sortie de classe B et les résistances R25 et R26 contribuent à compenser les effets inductifs liés à un fonctionnement à haute fréquence.

En revenant à la figure 5, celle-ci représente un amplificateur différentiel ayant des bornes de sortie o⁻ et o⁺ sur lesquelles apparaissent des tensions de sortie Vo1 et Vo2. La tension différentielle de sortie est Vod=Vo1-Vo2. La tension de mode commun de sortie est VCM=1/2(Vo1+Vo2). Les tensions Vo1 et Vo2 varient en opposition en raison de l'étage différentiel et des deux étages préamplificateurs identiques 11 et 12. Ainsi, pour une tension différentielle d'entrée Vid et un rapport résistif A=R2/R1, Vo1=VCM-A.Vid et Vo2=VCM+A.Vid. Le niveau de VCM doit être établi et régulé pour empêcher une saturation de sortie et les meilleurs résultats sont obtenus quand VCM est nul. En ce cas, Vo1=-Vo2=-A.Vd et l'excursion de sortie est la plus grande possible. En outre, la linéarité du signal de sortie est la meilleure possible.

Le fait de prévoir selon la présente invention une résistance réglable R10 en un point du circuit indirectement connecté aux deux sorties et sans effet dynamique présente un avantage important.

Les inventeurs ont trouvé que, dans le cas de l'exemple numérique donné ci-après, la précision requise pour la résistance R10 est d'environ 10% pour 100 mV de tension de mode commun de sortie, ce qui fournit un procédé extrêmement simple de réglage de VCM sans dégrader les autres caractéristiques de l'amplificateur.

Pour le circuit représenté en figure 5, la demanderesse a effectué des simulations dans les conditions suivantes :
- technologie BiCMOS auto-alignée, à double niveau de métal et à double niveau de silicium polycristallin, à caisson N, dans laquelle la précision de photolithographie est de 1,2 micromètre,
- tension d'alimentation : ± 2,5 V,
- R1 = R'1 = 25 ohms,
- R2 = R2' = 500 ohms, et
- charge de 100 ohms sur chaque sortie,
et a obtenu les résultats principaux suivants :
- consommation de courant : 16 mA,
- gain en boucle fermée à sortie unique : 20 dB,
- produit gain-bande passante à sortie unique : 600 MHz,
- marge de phase à sortie unique : 46°,
- gain en boucle fermée en différentiel : 26 dB,
- produit gain-bande passante en différentiel : 1,2 GHz,
- plage de tension d'entrée de mode commun : ± 1,25 V, et
- plage de tension de sortie en mode commun : ± 1,25 V.

Bien entendu, la présente invention est susoeptible de nombreuses variantes et modifications qui apparaîtront à l'homme de l'art. En particulier, dans un exemple de réalisation, on a décrit une mise en oeuvre à l'aide de composants bipolaires. Une mise en oeuvre similaire pourra être réalisée à l'aide de composants de type MOS ou encore d'une combinaison de composants bipolaires et MOS, un aspect essentiel de l'invention résidant dans la réalisation des préamplificateurs qui comprennent une paire de transistors à base commune dont chacune des branches est associée à l'entrée et à la sortie d'un miroir de courant, une branche du miroir de courant comprenant une résistance de réglage commune à l'autre préamplificateur du système.

## Revendications

1. Amplificateur à entrées et sorties différentielles comprenant :
une paire différentielle d'entrée (10) ;
un premier (11) et un deuxième (12) préamplificateur de tension à entrée différentielle et à sortie unique recevant chacun les deux sorties de la paire différentielle ;
un étage adaptateur d'impédance (13, 14) connecté à la sortie de chaque préamplificateur et dont la sortie constitue une des sorties de l'amplificateur ; et
caractérisé en ce qu'il comprend un moyen unique (R10) d'ajustement du courant de repos envoyé par les préamplificateurs (11, 12) aux étages adaptateurs (13, 14), d'où il résulte que la tension de mode commun peut être ajustée à une valeur souhaitée, le moyen unique d'ajustement du courant de repos (R10) étant lui-même connecté aux préamplificateurs (11, 12).

2. Amplificateur selon la revendication 1, dans lequel chaque préamplificateur comprend une première et une deuxième branches d'une paire de transistors à base commune (T3, T4), lesdites branches étant couplées par un miroir de courant (T5, T6), la sortie de la première branche constituant l'entrée d'un étage adaptateur, caractérisé en ce que la portion du miroir de courant associée à la deuxième branche comprend une résistance (R10) de réglage de courant commune aux deuxièmes branches des miroirs de courant de chacun des préamplificateurs.

3. Amplificateur selon la revendication 2, caractérisé en ce que :
la paire différentielle d'entrée comprend un premier et un deuxième transistors NPN (T1, T2) dont les collecteurs sont reliés à une borne d'alimentation haute (VCC) par des résistances de charge respectives (R11, R12), dont les bases reçoivent les entrées différentielles (e⁻, e⁺), et dont les émetteurs sont reliés ensemble à une borne d'alimentation basse (VEE) par une source de courant (I1) ;
chaque préamplificateur de tension comprend une paire de transistors à base commune constituée de troisième et quatrième transistors PNP (T3, T4) dont les émetteurs sont reliés aux collecteurs des premier et deuxième transistors (T1, T2), dont les bases sont reliées à une tension de polarisation (Vref) et dont les collecteurs sont reliés respectivement à l'entrée et à la sortie d'un miroir de courant, le collecteur du transistor de la première branche de la paire différentielle constituant la sortie vers l'étage adaptateur ; et
chaque miroir de courant comprend un cinquième et un sixième transistor NPN (T5, T6) dont les collecteurs sont reliés aux collecteurs des troisième et quatrième transistors (T3, T4), dont les émetteurs sont reliés à la borne d'alimentation basse par l'intermédiaire de première et deuxième résistances respectives (R13, R10), et dont les bases sont reliées ensemble et au collecteur du transistor (T6) de ladite deuxième branche, la résistance (R10) de la deuxième branche du miroir de courant étant commune aux premier et deuxième préamplificateur et constituant ladite résistanoe de réglage.

4. Amplificateur selon la revendication 2 ou 3, caractérisé en ce que ladite résistance de réglage est une résistance ajustable formée dans le circuit intégré contenant ledit amplificateur.

5. Amplificateur selon l'une quelconque des rendications 1 à 4, associé à des résistanoes (R1, R2) de détermination de gain, caractérisé en ce que lesdites résistances sont formées dans le circuit intégré contenant ledit amplificateur.

6. Amplificateur selon la revendication 4, caractérisé en ce que ladite résistance de réglage est une résistance ajustable par fusibles.

7. Amplificateur selon la revendication 4, caractérisé en ce que ladite résistance de réglage est une résistance ajustable par laser.

## Patentansprüche

1. Verstärker mit Differenz-Ein-und Ausgängen, umfassend:
ein Differenz- Eingangspaar (10);
einen ersten (11) und einen zweiten (12) Spannungsvorverstärker mit Differenzeingang und einzigem oder Eintakt-Ausgang;
eine jeweils mit dem Ausgang jedes Vorverstärkers verbundene Impedanzanpassungsstufe, deren Ausgang jeweils einen der Ausgänge des Verstärkers bildet;
**dadurch gekennzeichnet**, daß
der Verstärker eine einzelne Einstellvorrichtung (R10) zur Einstellung des von den Vorverstärkern (11,12) in die Anpassungsstufen (13,14) geschickten Ruhestroms aufweist, derart daß die Gleichtaktspannung auf einen gewünschten Wert eingestellt werden kann, wobei die einzelne definierte Einstellvorrichtung (R10) für den Ruhestrom ihrerseits mit den Vorverstärkern (11,12) verbunden ist.

2. Verstärker nach Anspruch 1, bei welchem jeweils jeder Vorverstärker einen ersten und einen zweiten Zweig bzw. Pfad eines Transistorpaars (T3,T4) mit gemeinsamer Basis aufweist und die genannten Zweige durch einen Stromspiegel (T5,T6) miteinander gekoppelt sind, wobei der Ausgang des ersten Zweiges den Eingang einer Anpassungsstufe bildet, dadurch gekennzeichnet daß der dem zweiten Zweig bzw. Pfad zugeordnete Teil des Stromspiegels einen Stromregelwiderstand (R10) aufweist, der den zweiten Zweigen bzw. Pfaden der Stromspiegel jedes der Vorverstärker gemeinsam ist.

3. Verstärker nach Anspruch 2, dadurch gekennzeichnet, daß:
das Differenzeingangspaar einen ersten und einen zweiten NPN-Transistor (T1,T2) aufweist, deren Kollektoren über entsprechende Widerstände (R11,R12) mit einem hohen Speisespannungsanschluß (VCC) verbunden sind, deren Basen die Differenz-Eingangsgrößen (e⁻,e⁺) zugeführt werden, und deren Emitter gemeinsam über eine Stromquelle (I1) mit einem niedrigen Speisespannungsanschluß (VEE) verbunden sind;
daß jeweils jeder Spannungsvorverstärker ein aus einem dritten und einem vierten NPN-Transistor (T3,T4) bestehendes Transistorpaar mit gemeinsamer Basis aufweist, deren Emitter jeweils mit den Kollektoren des ersten bzw. zweiten Transistors (T1,T2) , deren Basisanschlüße mit einer Vorspannung (Vref), und deren Kollektoren mit dem Eingang bzw. dem Ausgang eines Stromspiegels verbunden sind, wobei der Kollektor des Transistors des ersten Zweigs des Differenzpaars den Ausgang zur Anpassungsstufe bildet; und
daß jeweils jeder Stromspiegel einen fünften und einen sechsten NPN-Transistor (T5,T6) aufweist, deren Kollektoren jeweils mit den Kollektoren des dritten bzw. vierten Transistors (T3,T4) verbunden sind, deren Emitter über einen ersten bzw. einen zweiten Widerstand (R13,R10) mit einem niedrigen Speisespannungsanschluß verbunden sind, und deren Basisanschlüsse miteinander und mit dem Kollektor des Transistors (T6) des genannten zweiten Zweigs verbunden sind, wobei der Widerstand (R10) des zweiten Zweigs des Stromspiegels dem ersten und dem zweiten Vorverstärker gemeinsam ist und den genannten Regelwiderstand bildet.

4. Verstärker nach Anspruch 2 oder 3, dadurch gekennzeichnet, daß der genannte Regelwiderstand ein in der den genannten Verstärker enthaltenden integrierten Schaltung ausgebildeter einstellbarer Widerstand ist.

5. Verstärker nach einem der Ansprüche 1 bis 4, in Zuordnung zu Widerständen (R1,R2) zur Festlegung der Verstärkung, dadurch gekennzeichnet, daß die genannten Widerstände in der den genannten Verstärker enthaltenden integrierten Schaltung ausgebildete Widerstände sind.

6. Verstärker nach Anspruch 4, dadurch gekennzeichnet, daß der genannte Regelwiderstand ein mittels Abschmelzsicherungen einstellbarer Widerstand ist.

7. Verstärker nach Anspruch 4, dadurch gekennzeichnet, daß der genannte Regelwiderstand ein mittels Laser einstellbarer Widerstand ist.

## Claims

1. An amplifier having differential inputs and outputs that comprises:
an input differential pair (10);
a first (11) and a second (12) single ended output differential preamplifier that each receive the outputs of the differential pair;
a buffer stage (13, 14) connected to the output of each preamplifier whose output constitutes one of the outputs of the amplifier; and
characterized in that it comprises a single means (R10) for adjusting the quiescent current supplied by the preamplifiers (11, 12) to the buffer stages (13, 14), whereby the common mode voltage can be adjusted to a required value, the single means (R10) for adjusting the quiescent current being connected to the preamplifiers (11, 12).

2. An amplifier according to claim 1, in which each preamplifier includes a first and a second path of a pair of common-base transistors (T3, T4), said paths being coupled by a current mirror (T5, T6), the output of the first path constitutes an input to a buffer, characterized in that the portion of the current mirror associated with the second path includes a current adjusting resistor (R10) that is common to each of the second paths of the current mirrors of each preamplifier.

3. An amplifier according to claim 2, characterized in that:
the input differential pair includes first and second NPN transistors (T1, T2) whose respective collectors are connected to a high voltage supply (VCC) via respective load resistors (R11, R12), whose base terminals receive the differential inputs (e-, e+) and whose emitters are each connected to a low voltage supply (VEE) via a current source (I1);
each voltage preamplifier includes a pair of common-base transistors constituted by third and fourth PNP transistors (T3, T4) whose respective emitters are connected to the respective collectors of the first and second transistors (T1, T2), whose base terminals are each connected to a reference voltage (Vref) and whose collectors are respectively connected to an input and an output of a current mirror, the collector of the transistor of the first path of the differential pair constituting the output that is connected to the buffer; and
each current mirror includes a fifth and a sixth NPN transistor (T5, T6) whose respective collectors are connected to the respective collectors of the third and fourth transistors (T3, T4), whose respective emitters are connected to the low voltage supply via respective first and second resistors (R13, R10), and whose base terminals are connected together and to the collector of the transistor of said second path, the resistor of the second path of the current mirror being common to the first and second preamplifiers and constituting said adjustable resistor.

4. An amplifier according to claims 2 or 3, characterized in that said adjustable resistor is an adjustable resistor that is formed as part of the integrated circuit that contains said amplifier.

5. An amplifier according to any of the claims 1-4, including resistors (R1, R2) for determining the gain of the amplifier, characterized in that said resistors are formed as part of the integrated circuit that contains said amplifier.

6. An amplifier according to claim 4, characterized in that said adjustable resistor is a resistor that is adjustable by fuses.

7. An amplifier according to claim 4, characterized in that said adjustable resistor is a resistor that is adjustable by a laser trimming method.
